(19) Europäisches Patentamt
European Patent Office
Office européen des brevets

(11) **EP 2 418 512 A1**

(12) **EUROPÄISCHE PATENTANMELDUNG**

(43) Veröffentlichungstag:
**15.02.2012 Patentblatt 2012/07**

(51) Int Cl.:
***G01S 17/02*** *(2006.01)*     ***H03K 17/78*** *(2006.01)*

(21) Anmeldenummer: **10196902.0**

(22) Anmeldetag: **23.12.2010**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **30.07.2010 EP 10171461**

(71) Anmelder: **Mechaless Systems GmbH**
**76131 Karlsruhe (DE)**

(72) Erfinder: **Schweninger, Erhard**
**76149 Karlsruhe (GB)**

(74) Vertreter: **Durm & Partner**
**Moltkestrasse 45**
**76133 Karlsruhe (DE)**

(54) **Optoelektronische Messanordnung mit Fremdlichtkompensation**

(57) Die vorliegende Erfindung betrifft eine optoelektronische Messanordnung mit einer Fremdlichtkompensation mit einer Sendelichtquelle (2) und einer Kompensationslichtquelle (3), die Licht zeitsequentiell getaktet phasenweise aussenden, wobei das ausgesendete Licht jeweils phasenverschoben ist. Die Messanordnung umfasst einen optischen Empfänger (4), mit einer Photodiode (5) zum Empfangen von Licht, das ein von den Lichtquellen (2, 3) ausgesandtes taktsynchrones Nutzsignal umfasst, und mit einer Verstärkereinheit (6) zum Verstärken eines auf dem empfangenen Nutzsignal beruhenden Nutzsignalstroms, einen Taktgenerator (8) zur Erzeugung eines Taktsignals, einen Demodulator (11) zur taktsynchronen Auswertung des Nutzsignalstroms, eine regelbare Stromquelle (9) zur Erzeugung eines getakteten Sendesteuerstroms für die Sende-Lichtquelle (2), eine regelbare Kompensations-Stromquelle (10) zur Erzeugung eines getakteten Kompensationssteuerstroms für die Kompensationslichtquelle (3), und eine Reglereinheit (12) zur Erzeugung wenigstens eines Ansteuersignals für die regelbare Stromquelle (9) und/oder Kompensations-Stromquelle (10), wobei die Reglereinheit (12) so ausgebildet ist, dass die Kompensationslichtquelle (3) und/oder die Sende-Lichtquelle (2) durch Steuerung des Kompensationssteuerstroms und/oder des SendeSteuerstroms in ihrer Lichtintensität in der Amplitude derart regelbar ist, dass der zwischen unterschiedlichen Phasen auftretende taktsynchrone Nutzsignalstrom zu Null wird. Die Messanordnung hat eine steuerbare Grundkopplungs-Stromquelle (15) zur Erzeugung eines getakteten Grundkopplungs-Steuerstroms, wobei bevorzugt die Grundkopplungs-Stromquelle (15) mit dem Taktsignal des Taktgenerators (8) getaktet wird, eine Grundkopplungs-Lichtquelle (17), die von der Sende-Lichtquelle (2) verschieden ist und mit dem Grundkopplungs-Steuerstrom gespeist wird und Licht direkt zu dem optischen Empfänger (4) sendet, und der Grundkopplungs-Steuerstrom derart eingestellt wird, dass eine gewünschte Empfindlichkeit der Messanordnung (1) erzielt wird und/oder ein gewünschter Arbeitspunkt der Reglereinheit einstellbar ist, wobei ohne Anwesenheit eines zu erfassenden Objekts (13) die Reglereinheit (12) die Sende-Lichtquelle (2) und/oder die Kompensationslichtquelle (3) derart regelt, dass das von der Grundkopplungs-Lichtquelle (15) empfangene Nutzsignal ausgeregelt wird.

    **(Forts. nächste Seite)**

EP 2 418 512 A1

Fig. 2

**Beschreibung**

Die vorliegende Erfindung betrifft eine optoelektronische Messanordnung mit einer optischen Fremdlichtkompensation. Die Messanordnung umfasst neben einer Sendelichtquelle auch eine Kompensationslichtquelle, wobei beide Lichtquellen Licht zeitsequentiell getaktet aussenden und das ausgesendete Licht der beiden Lichtquellen jeweils phasenverschoben ist. Ein optischer Empfänger mit einer Photodiode empfängt das von den Lichtquellen ausgesandte Licht und verstärkt das Nutzsignal mittels eines Verstärkers, so dass ein Nutzsignalstrom erzeugt wird, der einer Reglereinheit zugeführt wird. Die für die Taktung der Lichtquellen notwendigen Taktsignale werden mittels eines Taktgenerators erzeugt und steuerbaren Stromquellen zugeführt. Eine steuerbare Stromquelle wird verwendet, um den getakteten Sendesteuerstrom für die Sendelichtquelle zu erzeugen und eine steuerbare Kompensationsstromquelle für die Erzeugung eines getakteten Kompensationssteuerstroms für die Kompensationslichtquelle.

Das von dem optische Empfänger empfangene Lichtsignal und des darauf beruhenden Nutzsignalstroms wird mittels eines Demodulators der Reglereinheit zur taktsynchronen Auswertung zugeführt. Die Reglereinheit erzeugt wenigstens ein Ansteuersignal für die regelbare Stromquelle oder die regelbare Kompensationsstromquelle. Dabei wird die Kompensationslichtquelle durch Steuerung ihres Kompensationssteuerstroms in ihrer Lichtintensität in der Amplitude derart geregelt, dass zwischen unterschiedlichen Phasen auftretende taktsynchrone Nutzsignale des empfangenen Lichtsignals zu Null werden.

Die Verwendung einer derartigen Fremdlichtkompensation ist im Stand der Technik beispielsweise aus der US 5,666,037, der EP 0 706 648 B1 sowie der EP 1 671 160 B1 bekannt. Eine derartige Messanordnung zeichnet sich dadurch aus, dass sie hoch empfindlich messen kann und gleichzeitig weitgehend unabhängig von Fremdlicht ist. Selbst bei einer starken Sonneneinstrahlung ist eine optische Messung möglich. Da das empfangene Umgebungslicht im Allgemeinen wesentlich stärker ist als der von der Nutzsignalquelle ausgestrahlte Lichtanteil, eignen sich diese fremdlichtkompensierenden Messanordnungen besonders beim Einsatz von Tageslicht oder in hellen Räumen. Ein Beispiel einer Messanordnung mit Fremdlichtkompensation ist als "Halios-Sensor" der Firma Elmos bekannt.

Die von diesen optischen Messanordnungen mit Fremdlichtkompensation ausgesandten Lichtstrahlen werden an den von den Sendern "beleuchteten" Objekten reflektiert und nach der Reflexion in der Messanordnung empfangen, wodurch Informationen über die Objekte gewonnen werden können, insbesondere die Position und/oder Bewegung eines Objekts erfasst werden. Dabei wird die Tatsache ausgenutzt, dass das Umgebungslicht niederfrequent gegenüber dem von der Sendelichtquelle ausgesandten Nutzsignal ist. Durch Signaltrennung wird nur der Nutzsignalanteil des entstehenden Photostroms der Photodiode verstärkt. Beispielsweise weist das von künstlicher Beleuchtung hervorgerufene Licht häufig Frequenzen von 50 oder 60 Hz sowie deren Harmonischen auf. Der von dem natürlichen Umgebungslicht oder Sonnenlicht herbeigeführte Anteil des Photostroms ist lediglich ein Gleichstromanteil. Der Nutzsignalanteil des empfangenen Lichts liegt jedoch abhängig von der Taktung in der Regel bei mehreren Kilohertz oder Megahertz oder mehr.

Bei einer optisch fremdlichtkompensierenden optoelektronischen Messanordnung wird das vvom Sender generierte Nutzlichtsignal an der Photodiode empfangen und die Kompensationslichtquelle derart eingestellt, dass das phasenverschobene Kompensationslichtsignal, das ebenfalls von der Photodiode empfangen wird, in der Amplitude gleich groß ist. Die phasenbezogene Differenz der beiden Signale ist somit gleich Null. Die Reglereinheit der Messanordnung regelt das Kompensationssignal entsprechend aus.

Ist kein Messobjekt vorhanden, so wird das von der Sendelichtquelle ausgesandte Licht nicht reflektiert und gelangt nicht zur Photodiode zurück. Um den Arbeitspunkt der Regeleinheit einzustellen, wird ein Teil des von der Sendelichtquelle ausgesandten Lichts direkt zur Photodiode übertragen. Unter der direkten Übertragung wird nicht nur der direkte Lichtanteil von der Sendediode zur Photodiode verstanden, bei dem sich die beiden Dioden "sehen", sondern auch der Anteil des von der Sendelichtquelle ausgesandten Lichts, der an Komponenten oder Teilen der optischen Messanordnung, wie beispielsweise einer Sensorabdeckung, reflektiert wird und auf diesem Weg zur Photodiode gelangt. Diese "direkt übertragenen" Anteile des Lichts werden als Grundkopplung oder optische Grundkopplung bezeichnet, da es Lichtanteile sind, die zur Photodiode gelangen, ohne dass ein Messobjekt im Lichtweg vorhanden ist.

Unter dem Begriff "Arbeitspunkt der Reglereinheit" wird der Ruhezustand der Reglereinheit verstanden, wenn kein Nutzlichtsignal vorhanden ist, also kein von einem Messobjekt zurückreflektierter Lichtanteil von der Photodiode gemessen werden kann. Der Arbeitspunkt wird durch einen bestimmten Punkt auf der Kennlinie der Reglereinheit beschrieben. Dabei wird in der Regel die Stromkennlinie zugrundegelegt, da die Sendelichtquelle über eine regelbare Stromquelle angesteuert wird. Die regelbare Stromquelle erzeugt typischerweise Ströme im Bereich von 0 bis 20 mA, gelegentlich auch im Bereich von 0 bzw. 4 mA bis ca. 50 oder 100 mA. Als Stromobergrenze können auch 70, 80 oder 90 mA vorgesehen sein. Der Arbeitspunkt der Reglereinheit wird entsprechend der Applikation oder Anwendung der optischen Messanordnung festgelegt. Soll lediglich das Vorhandensein eines Messobjekts direkt an einer Sensorabdeckung der Messanordnung detektiert werden, so wird der Arbeitspunkt bei einem höheren Stromwert anzusetzen sein als bei einer Messanordnung, die herannahende Objekte in einer Entfernung von beispielsweise 30 bis 50 cm von der Messanordnung erkennen soll.

Um den Arbeitspunkt entsprechend einzustellen, muss die optische Grundkopplung bei bekannten Messanordnungen, wie beispielsweise einem Halios-Sensor, durch strukturelle und konstruktive Maßnahmen eingestellt werden. Beispielsweise wird durch Abschattung der Photodiode oder der Sendelichtquelle verhindert, dass sich die beiden Photoelemente "sehen". Es werden nur an Komponenten oder Teilen der Messanordnung reflektierte Signalanteile zugelassen. Neben dem Einbau von Abschattungselementen können auch andere strukturelle Elemente eingesetzt werden. Beispielsweise ist es möglich, Reflexionen innerhalb der Messanordnung durch Aufrauen von Oberflächen oder Beschichten von Oberflächen zu reduzieren, zu erzeugen, zu verstärken oder zu verhindern.

Verwendet eine Messanordnung mehrere Sendelichtquellen, die unterschiedlich weit von dem optischen Empfänger entfernt sind, so ist für jede der Sendelichtquellen eine eigene optische Grundkopplung einzustellen. Die Grundkopplungen der einzelnen Sendelichtquellen sollen möglichst gleich sein, damit die mit den einzelnen Sendelichtquellen durchgeführten Messungen vergleichbar sind und in einem möglichst ähnlichen Messbereich liegen. Eine geeignete Einstellung der optischen Grundkopplung ist in der Regel sehr aufwändig und zeitintensiv, in seltenen Fällen auch gar nicht möglich. Es ist ein großes spezifisches Fachwissen erforderlich. Häufig lässt sich die gewünschte Grundkopplung nur im Wege eines trial- and error-Verfahrens erzielen, bei dem unterschiedliche Maßnahmen vorgenommen werden. Beispielsweise kann eine Beschichtung von Komponenten der Messanordnung mit nicht reflektierenden Farben oder Überzügen erfolgen oder der Einsatz optischer Elemente, wie Spiegel, die reflektierten Strahlen der Sendelichtquelle direkt zur Photodiode lenken, wenn dies notwendig ist.

Aus dem vorliegenden Stand der Technik ergibt sich die Aufgabe, eine verbesserte optoelektronische Messanordnung zu schaffen. Sie soll insbesondere die Möglichkeit einer vereinfachten und optimierten Einstellung der optischen Grundkopplung bieten.

Gelöst wird die vorliegende Aufgabe durch eine optoelektronische Messanordnung mit den Merkmalen des Anspruchs 1.

Die erfindungsgemäße optoelektronische Messanordnung weist eine optische Fremdlichtkompensation auf. Sie dient insbesondere zur Erfassung der Position und/oder Bewegung eines Objekts. Die Messanordnung umfasst eine Sendelichtquelle und eine Kompensationslichtquelle, die je Licht zeitsequentiell getaktet, phasenweise aussenden. Das jeweils ausgesendete Licht der Lichtquellen ist phasenverschoben zueinander. Die Messanordnung umfasst einen optischen Empfänger mit einer Photodiode zum Empfangen von Licht, das ein von den Lichtquellen ausgesandtes taktsynchrones Nutzsignal umfasst. Der optische Empfänger hat auch eine Verstärkereinheit zum Verstärken eines auf dem empfangenen Nutzsignal beruhenden Nutzsignalstroms. Ein Taktgenerator erzeugt ein Taktsignal, mit dem eine steuerbare Stromquelle zur Erzeugung eines getakteten Sendesteuerstroms für die Sendelichtquelle und mit dem eine steuerbare Kompensationsstromquelle zur Erzeugung eines getakteten Kompensationssteuerstroms für die Kompensationslichtquelle gespeist werden. Ein Demodulator der Messanordnung wird zur taktsynchronen Auswertung des Nutzsignalstroms, der mit der Photodiode empfangen wird, verwendet.

Die optoelektronische Messanordnung umfasst eine Reglereinheit zur Erzeugung wenigstens eines Ansteuersignals für die steuerbare Stromquelle und/oder die steuerbare Kompensationsstromquelle, wobei die Reglereinheit derart eingerichtet und ausgebildet ist, dass die Kompensationslichtquelle und/oder die Sendelichtquelle durch Steuerung des entsprechenden Steuerstroms (Kompensationssteuerstrom bzw. Sendesteuerstrom) in ihrer Lichtintensität in der Amplitude regelbar ist. Die Regelung erfolgt dabei derart, dass der zwischen verschiedenen Phasen auftretende taktsynchrone Nutzsignalstrom zu Null geregelt wird.

Erfindungsgemäß umfasst die optoelektronische Messanordnung eine steuerbare Grundkopplungsstromquelle zur Erzeugung eines getakteten Grundkopplungssteuerstroms. Die Grundkopplungsstromquelle wird bevorzugt ebenfalls mit dem Taktsignal des Taktgenerators getaktet. Eine Grundkopplungslichtquelle, die von der Sendelichtquelle verschieden ist und die mit dem Grundkopplungssteuerstrom gespeist wird, sendet Licht direkt zu dem optischen Empfänger. Der Grundkopplungssteuerstrom wird dabei derart eingestellt, dass eine gewünschte Empfindlichkeit der Messanordnung erzielt wird und/oder ein gewünschter Arbeitspunkt der Reglereinheit einstellbar ist. Daneben lässt sich optional oder zusätzlich die Stabilität der Regelung und die Dynamik (Aussteuerbereich und dynamisches Verhalten) der Reglereinheit gezielt beeinflussen. Dazu werden ohne Anwesenheit eines zu erfassenden Objekts die Sendelichtquelle und/oder die Kompensationslichtquelle mittels der Regeleinheit derart geregelt, dass das empfangene Nutzsignal, das von der Grundkopplungslichtquelle ausgesendet wird, ausgeregelt wird. Die Regelung erfolgt so, dass die phasenverschobenen Signale, die am optischen Empfänger gemessen werden, im Arbeitspunkt gleich sind und sich deshalb zu Null addieren. Bevorzugt wird die Grundkopplungslichtquelle also so geregelt, dass der gewünschte oder erforderliche Arbeitspunkt eingestellt werden kann. Der Grundkopplungssteuerstrom dient also zur Festlegung der Arbeitspunkte.

Die Grundkopplung ist definiert als der von der (Nutzsignal-)Lichtquelle ohne Reflexion an einem zu erfassenden Objekt reflektierte Anteil des von der (Nutzsignal-)Lichtquelle ausgestrahlten Lichts. Die Grundkopplung ist der Lichtanteil der Lichtquelle, der (ausschließlich) innerhalb der Messanordnung zur Photodiode transportiert bzw. geleitet oder gestrahlt wird (mit oder ohne Reflexion innerhalb der Messanordnung).

Die optische Fremdlichtkompensation setzt einen ausgeregelten Zustand (Grundzustand) voraus. Dazu ist ein optischer Grundkopplungsanteil erforderlich, der von der Anwendung oder Applikation abhängt. Die gewünschte oder notwendige optische Grundkopplung wird in der Regel durch konstruktive Maßnahmen eingestellt. Dies ist insbesondere bei mehreren Sendelichtquellen in dem Sensor (Messanordnung) sehr aufwändig. Verschmutzungen, Feuchtigkeit und/ oder Kratzer an der Sensoroberfläche können die optische Grundkopplung zudem verändern.

Um eine gewünschte Empfindlichkeit einzustellen, wird ein vorgegebener Prozentsatz (beispielsweise zwischen 10 und 20 %) des maximal reflektierten Signalanteils der funktionalen Kopplung (von einen Objekt reflektierter Anteil an Licht bzw. der korrespondierende Strom im Sensor) eingestellt. Dies gilt z. B. wenn ein Objekt direkt am Sensor/ Empfänger angeordnet ist oder in einem vorgegebenen Bereich von Entfernung oder in einem relevanten (vorgegebenen) Abstand zum Sensor (Empfänger). Ist das Objekt am nächsten, so ist die maximale Regelung notwendig, also der maximale KompensationsSteuerstrom.

Bei der Erfindung wurde die Erkenntnis genutzt, dass bei optisch fremdlichtkompensierenden Messanordnungen eine optische Kopplung zwischen der Sendelichtquelle und der Photodiode des Photoempfängers besteht, die sich aus zwei Anteilen zusammensetzt. Der erste Anteil der optischen Kopplung ist der funktionale und zu bestimmende Sendekopplungsanteil. Der zweite Anteil der optischen Kopplung ist die sogenannte (optische) Grundkopplung des Senders. Diese muss sehr genau definiert werden, denn sie hat für die optische Messanordnung mehrfache Auswirkungen. Zum einen ist die Grundkopplung der Senderlichtquelle genau die Messgröße, mit der die Reglereinheit arbeitet, solange kein Messobjekt vorhanden ist. Die Grundkopplung bestimmt deshalb insbesondere den Ruhewert der Messanordnung und somit den Arbeitspunkt der gesamten Anordnung.

Zudem wird durch Einstellen der Grundkopplung die Empfindlichkeit der Messanordnung und somit die Reichweite des Sensors beeinflusst. Durch Einstellung der Empfindlichkeit bzw. durch Änderung der Grundkopplung kann bestimmt werden, in welcher Entfernung von der Messanordnung ein Objekt noch erkannt werden kann.

Der weitere Einfluss der Grundkopplung auf die Messschaltung der Messanordnung ist die von der Grundkopplung hervorgerufene Rauschleistung in der Messanordnung und die damit verbundene Einschwingzeit des Sensorsignals. Somit hat die Grundkopplung also Einfluss auf die Geschwindigkeit, mit der Messobjekte erkannt werden können.

In einer im Stand der Technik bekannten Messanordnung, bei der die Sendelichtquelle in der Nähe des optischen Empfängers und der Photodiode angeordnet ist, ist es möglich, die optische Grundkopplung der Sendelichtquelle durch ein optisches Design nahezu beliebig zu reduzieren. Durch konstruktive Maßnahmen wie Abschirmung, Einbauen von Hindernissen oder gewollte Mehrfachreflexion des von der Sendelichtquelle ausgesandten Lichtstrahls innerhalb der optischen Messanordnung kann die Grundkopplung gering bis sehr gering gehalten werden. Bei Sendelichtquellen, die von dem optischen Empfänger relativ weit entfernt sind, ist die Grundkopplung grundsätzlich deutlich geringer.

Aus der Tatsache, dass die optische Grundkopplung der Messanordnung stark reduziert werden kann, so dass sie bevorzugt nahezu vernachlässigbar ist, wurde im Rahmen der Erfindung erkannt, dass die optische Grundkopplung der Sendelichtquelle ersetzt werden kann durch eine elektrooptische Grundkopplung einer Grundkopplungslichtquelle, die bevorzugt von der Sendelichtquelle verschieden sein kann. Die Grundkopplungslichtquelle ist bevorzugt derart angeordnet, dass ihr Licht direkt zu dem optischen Empfänger gesandt wird. Bevorzugt wird die Grundkopplungslichtquelle durch geeignete Maßnahmen abgeschirmt, so dass das ausgesandte Licht ausschließlich in den Empfänger gelangen kann. Die Einstellung erfolgt also ohne einen von einem Messobjekt oder der Messanordnung reflektierten Lichtanteil. Durch eine geeignete Ansteuerung der Grundkopplungslichtquelle ist die elektrooptische Grundkopplung beliebig einstellbar. Die physikalische Grundkopplung eines vorhandenen Systems lässt sich somit erhöhen. Der Arbeitspunkt der Reglereinheit kann gezielt und einfach festgelegt und eingestellt werden.

Dazu wird eine steuerbare Grundkopplungsstromquelle verwendet, die einen getakteten Grundkopplungssteuerstrom zur Ansteuerung der Grundkopplungslichtquelle erzeugt. Die Grundkopplungslichtquelle ist derart ansteuerbar, dass die gewünschte Empfindlichkeit der Messanordnung eingestellt werden kann. Darüber hinaus ist es möglich durch Einstellung und Regelung des Grundkopplungssteuerstroms den Arbeitspunkt der Reglereinheit frei zu definieren und derart einzustellen, dass er für die jeweilige Applikation der Messanordnung optimiert ist. Somit kann auch ohne Anwesenheit eines zu erfassenden Objekts die Reglereinheit ausgeregelt werden, so dass eine hohe Fremdlichtunabhängigkeit der Messanordnung erhalten bleibt.

Vorteilhafterweise können so bisherige Messanordnungen des Stands der Technik mit einer Fremdlichtkompensationsschaltung verbessert werden. Insbesondere für Messanordnungen, bei denen wenigstens eine der Sendelichtquellen weit von der Photodiode entfernt ist, lässt sich auf diese Weise die Grundkopplung optimieren. Die elektrische Erzeugung der optischen Grundkopplung kann für jede Sendelichtquelle individuell angepasst sein. Jede der einzelnen Regelschleifen bestehend aus dem optischen Empfänger und der jeweiligen Sendelichtquelle lassen sich somit individuell mit den notwendigen Werten der Grundkopplung ausstatten.

Durch Einsatz einer elektrisch erzeugten optischen Grundkopplung mittels einer Grundkopplungslichtquelle entfällt folglich der hohe konstruktive Aufwand, die optische Grundkopplung der Sendelichtquelle einzustellen. Damit wird die Entwicklung und Herstellung derartiger Messanordnungen deutlich günstiger und preiswerter. Die Entwicklung kann schneller erfolgen. Durch diesen Ansatz ist gerade bei der Verwendung mehrerer Sendelichtquellen, die teilweise weit von dem optischen Empfänger entfernt sind, überhaupt erst eine Serienproduktion von derartigen Messanordnungen möglich bzw. wirtschaftlich interessant. Somit steigt auch die Akzeptanz der Anwender für derartige Messanordnungen mit Fremdlichtkompensation. Die erfindungsgemäße Messanordnung überwindet somit die Nachteile im Stand der Technik.

Im Rahmen der Erfindung wurde erkannt, dass in einer bevorzugten Ausführungsform die Grundkopplungslichtquelle, die mit dem Grundkopplungssteuerstrom gespeist wird, die Kompensationslichtquelle sein kann. Die Messanordnung umfasst in diesem Fall ein Summierglied, in dem der Grundkopplungssteuerstrom und der Kompensationssteuerstrom addiert werden, bevor der addierte Steuerstrom der Kompensationslichtquelle zugeführt wird. Es lässt sich die Messanordnung somit ohne eine weitere Lichtquelle für die elektrooptische Grundkopplung ausrüsten. Es ist lediglich eine weitere steuerbare Grundkopplungsstromquelle notwendig. Die Kompensationslichtquelle wird dann mit zwei phasenverschobenen Steuerströmen betrieben.

Überraschenderweise wurde auch festgestellt, dass bisherige Messanordnungen ohne Fremdlichtkompensation in einfacher Art und Weise verbessert werden können. Bei Messsystemen ohne Fremdlichtkompensation findet eine Abschattung der Sendelichtquelle von dem optischen Empfänger statt. Um die Messsysteme für Fremdlichtkompensation einsetzbar zu machen, ist es lediglich notwendig, eine Kompensationslichtquelle vorzusehen, die auch die optische Grundkopplung der Sendelichtquelle übernehmen kann.

In einer bevorzugten Ausführungsform der optoelektronischen Messanordnung wird der Grundkopplungssteuerstrom derart eingestellt bzw. eingeregelt, dass die Grundkopplung der Sendelichtquelle ersetzt wird. Dazu wird bevorzugt die Sendelichtquelle derart in der Messanordnung angeordnet, dass ihre optische Grundkopplung (physikalische Grundkopplung zwischen der Sende-lichtquelle und der Photodiode) maximal 10 % des von ihr ausgestrahlten Lichts ist. Bevorzugt ist die optische Grundkopplung möglichst klein (5 % oder 2 % oder 1 %), besonders bevorzugt annähernd Null. In einer bevorzugten Ausführungsform der Messanordnung besteht keine direkte Grundkopplung zwischen der Sendelichtquelle und der Photodiode des optischen Empfängers. Die elektrooptische Grundkopplung, die durch Regelung des Grundkopplungssteuerstroms der Grundkopplungsstromquelle erzeugt wird, ersetzt folglich die geringe oder nicht vorhandene optische Grundkopplung der Sendelichtquelle.

In einer bevorzugten Ausführungsform umfasst eine Messanordnung mehrere Sendelichtquellen, die sequentiell hintereinander in einer Regelschleife durch die Kompensationslichtquelle kompensiert werden. Dazu erfolgt mittels des Reglers für jede der Sendelichtquellen eine Kompensation mit der Kompensationslichtquelle. Für jede dieser Regelschleifen wird jeweils ein optimierter und angepasster Grundkopplungssteuerstrom erzeugt, mit dem die regelbare Kompensationssteuerquelle angesteuert wird. Auf diese Weise kann für jede einzelne Sendelichtquelle eine individuelle elektrooptische Grundkopplung erzeugt werden.

In der Regel sind bei optoelektronischen Messanordnungen in der Praxis die Regeleinheiten, Demodulatoren, Taktgeneratoren und Verstärker in einem Chip integriert. In diesem integrierten elektrischen bzw. elektronischen Bauteil sind auch die Signalgeber für die regelbaren Stromquellen bevorzugt umfasst. Die Stromquellen, insbesondere die steuerbare Sendelichtstromquelle und die Grundkopplungsstromquelle werden von einem oder von mehreren Signalgebern gespeist. Bei einer Integration der Signalgeber, insbesondere des Signalgebers zur Steuerung der Grundkopplungsstromquelle entstehen in der Realisierung der optoelektronischen Messanordnung keine (Hardware-) Mehrkosten. Lediglich bei der Chipentwicklung muss einmal ein höherer Aufwand getrieben werden. Insoweit ist die erfindungsgemäße optoelektronische Messanordnung sehr kostengünstig.

Die erfindungsgemäße Messanordnung weist eine Vielzahl von Vorteilen auf. Durch die elektrische Realisierung der optischen Grundkopplung ergibt sich ein deutlich reduzierter Aufwand beim optischen Design (Optik-Design) der Messanordnung. Die Optik muss von den bisherigen drei technischen Schwerpunkten, nämlich möglichst optimales Senden, möglichst optimales Empfangen und eine entsprechende optische Grundkopplung, nur noch zwei dieser Anforderungen gleichzeitig erfüllen. Daraus ergeben sich deutlich geringere Anforderungen an das mechanische Design der Messanordnung, insbesondere an die konstruktive Ausgestaltung. Da keine optische Grundkopplung von der Sendelichtquelle zum optischen Empfänger erfolgen muss, können praktisch die oft kritischen Grundkopplungspfade umgangen werden, die in den bisherigen Sensoren, insbesondere in den Halios-Sensoren eingesetzt werden mussten. Diese optischen Grundkopplungspfade waren deshalb so kritisch, weil sie auf rein optischen Gegebenheiten beruhten. Beispielsweise beeinflussen Bauteiltoleranzen, Materialeinflüsse und Montagetoleranzen die Grundkopplung. Darüber hinaus war zur Realisierung ein hohes fachspezifisches Wissen über die Grundkopplung und die optischen Strahlengänge im Sensor notwendig. Durch die erfindungsgemäße Messanordnung werden nun auch herkömmliche Sensoranwendungen nutzbar. Die Erfindung hat somit großen kommerziellen Wert und Nutzen, da herkömmliche Sensoren und Messaufbauten optimiert werden können, ohne die Optik bzw. die optisch wirksamen Bestandteile neu auslegen zu müssen.

Es hat sich auch als vorteilhaft erwiesen, dass die meisten Einflüsse auf die optische Grundkopplung entfallen. Die nicht vernachlässigbaren Einflüsse durch temperaturkonstruktive Toleranzen und mechanische Spannungen oder Änderungen entfallen praktisch vollständig, ebenso Einflüsse von Außen, wie beispielsweise ein Verschmutzen, Feuchte oder Verkratzen einer (teil-) transparenten Sensoroberfläche. An einer Sensorabdeckung, an der bisher ein Teil des optischen Signals zur Photodiode direkt reflektiert und zurückgekoppelt wurde, haben Verschmutzungen an der Oberfläche zu einer Änderung der Reflexion und damit der optischen Grundkopplung geführt. Diese Einflüsse entfallen nun.

Es hat sich auch gezeigt, dass mit der erfindungsgemäßen Messanordnung und der elektrooptischen Grundkopplung ein einfacheres Schaltungslayout der gesamten Schaltungsplatine der Messanordnung (PCB-Layout) erfolgen kann. Das Layout der Schaltung ist direkt durch die optischen und mechanischen Anforderungen bestimmt. Diese sind jedoch deutlich reduziert. Ebenso ermöglicht die erfindungsgemäße Messanordnung eine exakte elektronische Realisierung der optimalen Grundkopplung in der Messanordnung. Dies ist für jede Sendelichtquelle und für die daraus entstehende Regelschleife einfach möglich und zwar unabhängig von der nicht vorhandenen oder vernachlässigbaren optischen Grundkopplung zwischen Sendelichtquelle und optischem Empfänger. Dadurch ergeben sich auch optimale Rauschwerte und Einschwingzeiten bei einer vorgegebenen Strahlungsleistung. Die Messanordnung arbeitet deshalb schneller und exakter.

Des Weiteren hat die Messanordnung ein vorteilhaftes thermisches Verhalten, da praktisch nur noch eine Lichtquelle bzw. LED, nämlich bevorzugt die Kompensationslichtquelle in die Grundkopplung einbezogen und an der Festlegung des Arbeitspunktes beteiligt ist. Dieser Effekt macht sich insbesondere bei der Bestimmung des Arbeitspunktes selbst und bei dessen Einstellung sowie bei der Einstellung der Empfindlichkeit der Messanordnung bemerkbar.

Die Reduzierung oder der Wegfall der direkten optischen Grundkopplung von der Sendelichtquelle zur Photodiode erlaubt ein vereinfachtes konstruktives Design und deutlich verkürzte Entwicklungszeiten. Die Kombination des einfachen Designs mit der schnelleren und effektiveren Einstellmöglichkeit der elektrooptischen Grundkopplung verkürzen Entwicklungszeiten. Wo bisher z. B. Lichtleiter aufwändig simuliert und produziert werden mussten, kann mittels der Methode der elektrooptischen Grundkopplung der Strom der Grundkopplungslichtquelle, z. B. durch Austausch eines Widerstands, verändert werden und praktisch sofort eine neue Abstimmung des Sensors erfolgen, der direkt getestet werden kann.

Ein weiterer Vorteil der Anordnung ergibt sich durch die freie Konfigurierbarkeit ein und derselben (physikalischen) Regelschleife, um nacheinander, also beispielsweise im Zeitmultiplex, grundsätzlich verschiedene Aufgaben mit der Messanordnung zu lösen. Es können so beispielsweise Annäherungsmessungen in großem Abstand (wie etwa zwischen 20 und 70 cm) bei dem Durchlauf einer Regelschleife erfolgen, während in der nächsten Regelschleife die Erkennung der Berührung einer Sensoroberfläche (Touch-Erkennung) durchgeführt wird. Damit ist das System sehr flexibel, da die Grundkopplung auf elektrooptischem Wege für jeden Regelzyklus angepasst werden kann. Die Messanordnung ist somit sehr flexibel und vielseitig einsetzbar. Sie weist eine hohe Stabilität auf, bei der der Arbeitspunkt gezielt einstellbar ist, beispielsweise nach kundenspezifischen Wünschen bzw. Anforderungen oder für besondere Anwendungen. Beispielsweise kann durch eine gezielte Abstimmung des Arbeitspunkts die Sensibilität und Empfindlichkeit des Sensors erhöht werden, andererseits lässt sich auch die Robustheit der Regelung verbessern.

Die Erfindung wird nachfolgend anhand von in den Figuren dargestellten besonderen Ausführungsformen näher erläutert. Die dort dargestellten Besonderheiten können einzeln oder in Kombination verwendet werden, um bevorzugte Ausgestaltungen der Erfindung zu schaffen. Die beschriebenen Ausführungen stellen keine Einschränkung der durch die Ansprüche in ihrer Allgemeinheit definierten Erfindung dar. Es zeigen:

Fig. 1          ein Prinzipbild einer Messanordnung des Stands der Technik;

Fig. 2          eine Prinzipschaltung der erfindungsgemäßen Messanordnung mit Fremdlichtkompensation;

Fig. 3          eine Prinzipschaltung einer weiteren Ausführungsform der erfindungsgemäßen Messanordnung mit Fremdlichtkompensation;

Fig. 4          eine Prinzipschaltung einer Ausführungsform der elektrooptischen Grundkopplung für die Messanordnung gemäß Fig. 2;

Fig. 5          eine alternative Ausführungsform der elektrooptischen Grundkopplung;

Fig. 6a, b, c, d    weitere Realisierungsmöglichkeiten der elektrooptischen Grundkopplung.

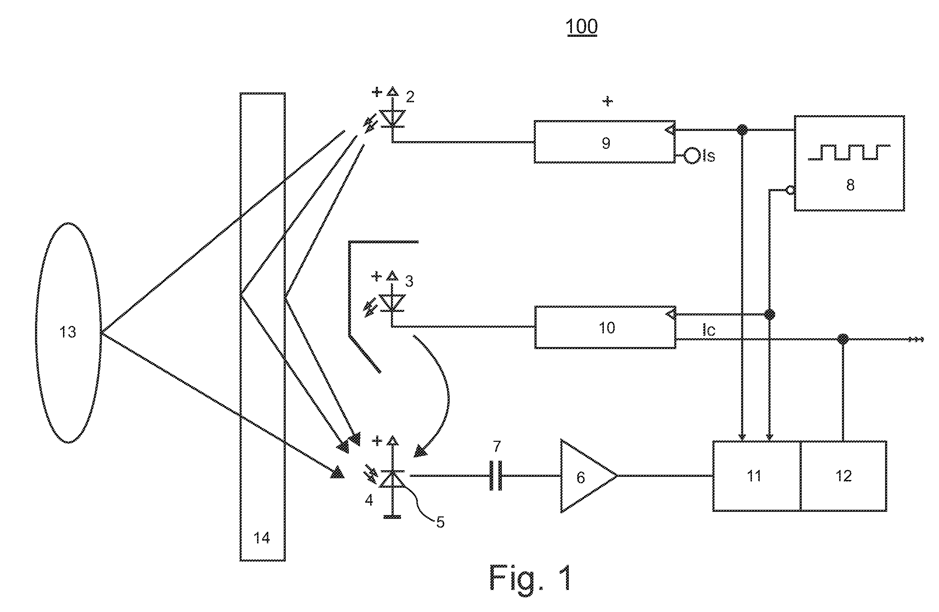

Fig. 1 zeigt eine Messanordnung 100 gemäß dem Stand der Technik mit einer Fremdlichtkompensation. Die Messanordnung 100 umfasst eine Sendelichtquelle 2, eine Kompensationslichtquelle 3 und einen optischen Empfänger 4, der eine Photodiode 5 und eine Verstärkereinheit 6 einschließt. Die Verstärkereinheit 6 ist als Transimpedanzverstärker ausgebildet, wobei zwischen dem Transimpedanzverstärker 6 und der Photodiode 5 ein Kondensator 7 geschaltet ist.

Ein Taktgenerator 8 taktet eine steuerbare Stromquelle 9, die die Sendelichtquelle 2 speist. Der Taktgenerator 8 liefert auch ein invertiertes Taktsignal an eine steuerbare Kompensationsstromquelle 10, die die Kompensationslichtquelle 3 speist. Sowohl das Taktsignal als auch das invertierte Taktsignal des Taktgenerators 8 werden einem Demodulator 11 zur taktsynchronen Auswertung des von dem optischen Empfänger 4 auf Grund des empfangenen Lichtsignals erzeugten Nutzsignalstroms zugeführt.

Eine Reglereinheit 12 der Messanordnung 100 erzeugt ein Ansteuersignal für die regelbare Kompensations-stromquelle 10, so dass die Kompensationslichtquelle 3 derart geregelt werden kann, dass der zwischen unterschiedlichen Phasen auftretende taktsynchrone Nutzsignalstrom, der auf den von der Sendelichtquelle 2 und der Kompensationslichtquelle 3 ausgesandten Lichtanteilen beruht, zu Null wird.

Ist ein Messobjekt 13 in der Nähe der Messanordnung 100 vorhanden, so wird von der Sendelichtquelle 2 ausgestrahltes Licht an dem Messobjekt 13 reflektiert und zur Photodiode 5 zurückgesandt. Neben diesem Signalanteil empfängt die Photodiode 5 auch die von der Sendelichtquelle 2 ausgesandte optische Grundkopplung. Als weitere Komponente empfängt die Photodiode 5 den von der Kompensationslichtquelle 3 ausgesandten Lichtanteil.

Zur Ausregelung der Messanordnung 100 ergibt sich damit folgende Regelbedingung:

$$\frac{I_c}{I_s} = \frac{\eta_s}{\eta_c} \cdot \frac{D_{SG} + D_{SF}}{D_c} \qquad \text{(Gleichung 1)}$$

$I_c$ und $I_s$ sind die Ansteuersignale bzw. Ansteuerströme für die regelbare Stromquelle 9 der Sendelichtquelle 2 bzw. für die regelbare Kompensations-stromquelle 10 der Kompensationslichtquelle 3. $\eta_s$ bzw. $\eta_c$ ist die jeweilige Effizienz der Sendelichtquelle 2 bzw. der Kompensationslichtquelle 3. $D_{SG}$ ist die auf der Grundkopplung beruhende Dämpfungsfunktion der Übertragungsstrecke zwischen Sendelichtquelle 2 und Photodiode 5. $D_{SF}$ ist die auf dem am Messobjekt 13 reflektierten Lichtanteil beruhende Dämpfung der Übertragungsstrecke der Sendelichtquelle 2, während $D_c$ die konstante Dämpfungsfunktion der Kompensationslichtquelle 3 ist.

Die Grundkopplung ($D_{SG}$) wird im Stand der Technik auf gewünschte Weise eingestellt durch eine entsprechende Konstruktion und optofunktionale Gestaltung der Messanordnung 100. Der Anteil $D_{SF}$ ist der gesuchte Anteil, der die Informationen über das Messobjekt 13 enthält.

Bei der Verwendung gleicher Lichtquellen sind die Effizienz der Sendelichtquelle 2 und der Kompensationslichtquelle 3 in der Regel gleich, jedenfalls aber bekannt. So kann das Verhältnis gemäß Gleichung 1 bestimmt werden. Das Ansteuersignal 1, für die steuerbare Stromquelle 9 der Sendelichtquelle 2 ist bekannt und in der Regel konstant. Der zu ermittelnde Ansteuerstrom $I_c$ für die Kompensationsstromquelle 10, der von der Reglereinheit 12 bestimmt wird, ergibt sich somit in Abhängigkeit der Übertragungsfunktionen der Kompensationslichtquelle 3 und der Sendelichtquelle 2.

Ist kein Messobjekt 13 vorhanden, so ist die Übertragungsfunktion $D_{SF}$ gleich Null. Der Arbeitspunkt wird folglich primär durch die optische Grundkopplung bestimmt und eingestellt.

Nachteilig im Stand der Technik ist, dass die optische Grundkopplung durch rein konstruktive Maßnahmen der Messanordnung 1 erzielt werden muss. Beispielsweise kann eine vorhandene Sensorabdeckung 14, die teiltransparent sein kann, in einigen Bereichen derart beschichtet sein, dass eine gewünschte Grundkopplung erzielt wird. Insbesondere bei weit von der Photodiode 5 entfernten Sendelichtquellen 2 ist der Grundkopplungsanteil jedoch üblicherweise gering, so dass teilweise nicht der gewünschte Arbeitspunkt eingestellt werden kann. Dies gelingt erst, indem durch zum Teil aufwändige konstruktive Maßnahmen die Grundkopplung verbessert bzw. erhöht wird.

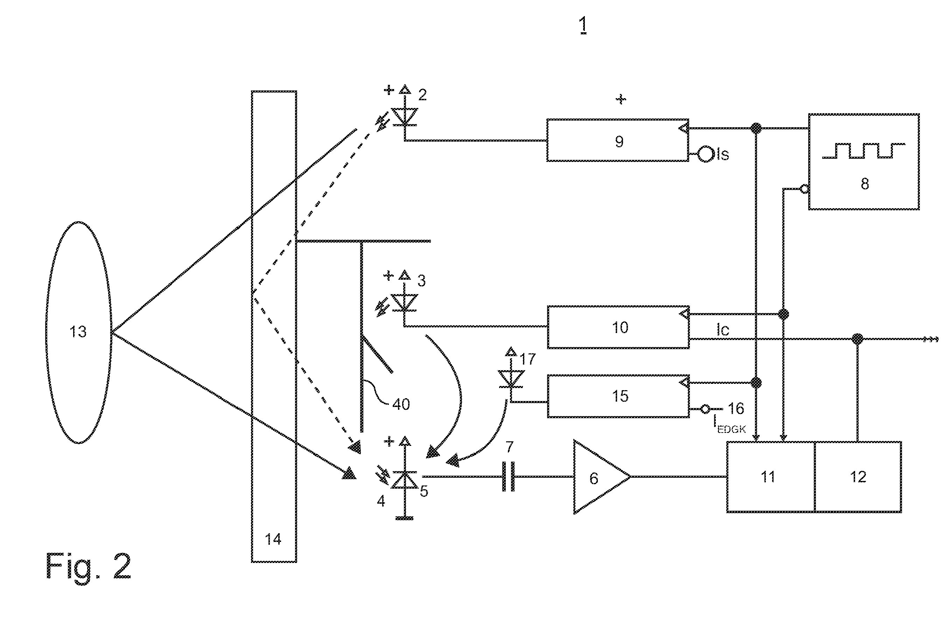

Im Vergleich dazu zeigt Fig. 2 eine erfindungsgemäße Messanordnung 1, bei der die Grundkopplung der Sendelichtquelle 2 derart gering ist, dass sie höchstens 7 % oder 5 % beträgt oder vernachlässigt werden kann. Dies kann beispielsweise durch einfache konstruktive Maßnahmen erzielt werden, wenn eine starke Grundkopplung vorhanden ist. Beispielsweise kann eine Abschirmung der Sendelichtquelle 2 von der Photodiode 5 erfolgen, z. B. durch die Abschirmung 40.

Zusätzlich zu der regelbaren Stromquelle 9 und der regelbaren Kompensationsstromquelle 10 umfasst die erfindungsgemäße Messanordnung 1 eine weitere regelbare Stromquelle, die Grundkopplungsstromquelle 15. Sie wird zum einen mit dem Taktsignal des Taktgenerators 8 getaktet. Gleichzeitig wird sie von einem Signalgeber 16, dem sogenannten Grundkopplungssignalgeber gespeist. Der in der Grundkopplungsstromquelle 15 erzeugte getaktete Grundkopplungssteuerstrom wird einer Grundkopplungslichtquelle 17 zugeführt, die Licht direkt zu der Photodiode 5 strahlt.

Die rein optische Grundkopplung der Sendelichtquelle 2 wird also ersetzt durch eine elektrisch erzeugte optische Grundkopplung, die mit der Grundkopplungslichtquelle 17 hergestellt wird. Diese elektrooptische Grundkopplung der Grundkopplungslichtquelle 17 hat den Vorteil, dass sie durch die direkte Einstrahlung auf die Photodiode nur vom Ansteuersignal und nicht von der Konstruktion der Messanordnung abhängt. Sie lässt sich deshalb frei und optimal einstellen. Somit ist die erfindungsgemäße Messanordnung 1 den bekannten Messanordnungen 100, wie z. B. einem sogenannten "Halios-Sensor", überlegen.

Fig. 2 ist zu entnehmen, dass die Grundkopplungslichtquelle 17 mit dergleichen Phase getaktet ist wie die Sendelichtquelle 2. Diese Phasen sind gegenüber der Phase der Kompensationslichtquelle 3 phasenverschoben. Bevorzugt liegt die Phasenverschiebung bei 180 Grad.

In einer bevorzugten Ausführungsform sind die Sendelichtquelle 2 und die Kompensationslichtquelle 3 und/ oder die Grundkopplungslichtquelle 17 als lichtimitierende Diode, also als LED, ausgeführt.

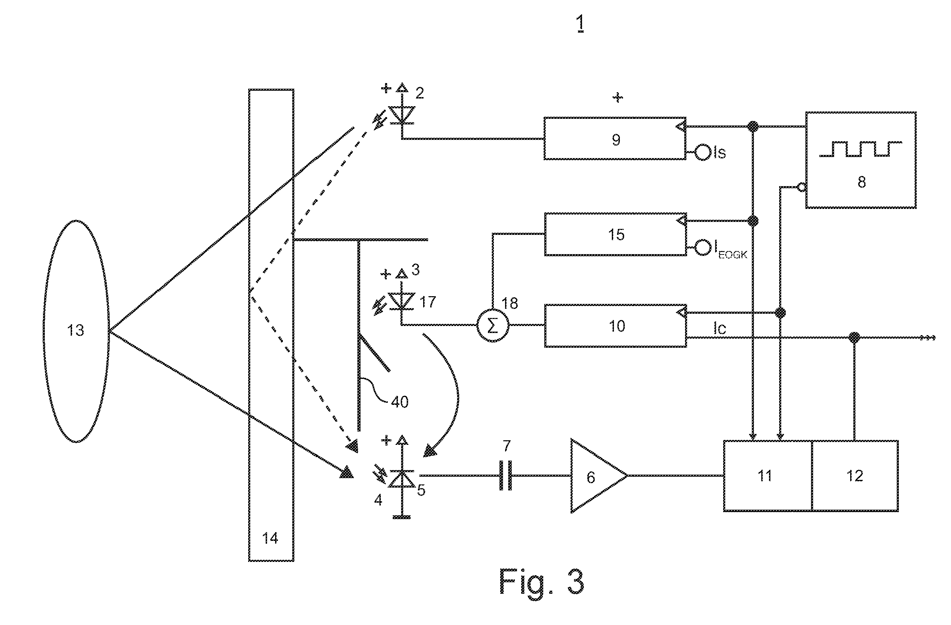

Fig. 3 zeigt eine alternative Ausführungsform der erfindungsgemäßen Messanordnung 1, bei der die Grundkopplungslichtquelle 17 die Kompensationslichtquelle 3 ist. Die Kompensationslichtquelle 3 übernimmt also die Funktion der Grundkopplungslichtquelle 17. Die regelbare Grundkopplungsstromquelle 15 speist folglich die Kompensationslichtquelle 3 ebenso wie die regelbare Kompensationsstromquelle 10. Bevorzugt werden der Kompensationssteuerstrom für die Kompensationsstromquelle 10 und der Grundkopplungssteuerstrom für die Grundkopplungsstromquelle 15 in einem Additionsglied 18 miteinander addiert und gemeinsam der Kompensationslichtquelle 3 zugeführt. Da die Steuerströme der Grundkopplungsstromquelle 15 und der Kompensationsstromquelle 10 phasenverschoben sind, ergibt sich ein überlagerter Steuerstrom. Hat beispielsweise der Steuerstrom für die Sendelichtquelle 2 die Phase A und der Steuerstrom für die Kompensationslichtquelle 3 die Phase B, so wird der Kompensationslichtquelle 3 durch das Additionsglied 18 neben einem Speisestrom der Phase B auch ein Speisestrom der Phase A eingeprägt, so dass die gewünschte Grundkopplung der Messanordnung in der Photodiode 5 generiert wird. Ein direkter Lichtanteil von der Sendelichtquelle 2 ist nicht notwendig bzw. unerwünscht. Er wird durch den entsprechenden Lichtanteil von der Kompensationslichtquelle mit der Phase A (Phase der Sendelichtquelle 2) kompensiert.

Die optische Grundkopplung wird also durch das Ansteuersignal ($I_{EOGK}$) zur Ansteuerung der Grundkopplungsstromquelle 15 festgelegt. Da dies durch einen elektrischen Signalgeber 16 erfolgt, ist die Grundkopplung auch später auf einfache Weise änderbar. Es muss lediglich ein anderes (geändertes) Ansteuersignal für die Grundkopplungsstromquelle 15 erzeugt werden. Die erfindungsgemäße Messanordnung 1 ist insgesamt sehr flexibel und kann auch im Nachhinein für andere Aufgaben adaptiert werden. Es sind keine konstruktiven Maßnahmen innerhalb der Messanordnung 1 notwendig, insbesondere keine zusätzlichen Abschirmungen oder Beschichtungen einer Sensorabdeckung 14 oder Abdeckung der Messanordnung 1. So lässt sich auch später der Arbeitspunkt der Messanordnung 1 noch verändern und somit die Empfindlichkeit oder Dynamik oder Genauigkeit an neue oder geänderte Anforderungen anpassen.

In der Regel ist davon auszugehen, dass die direkte optische Grundkopplung von der Sendelichtquelle 2 zum optischen Empfänger 4 deutlich unter 10 % liegt. In der Praxis ist die optische Grundkopplung maximal 6 %, 5 % oder darunter. Insbesondere bei weiter entfernten Sendelichtquellen 2, wie es beispielsweise bei relativ schlanken Konstruktionen und Messanordnungen 1 der Fall ist, liegt die optische Grundkopplung bei 3 %, 2 % oder maximal 1 %. Es ist ohne Weiteres möglich, bei weiter entfernt liegenden Sendelichtquellen 2 die optische Grundkopplung mittels geringem Aufwand und durch einfache Maßnahmen auf maximal 0,5 % oder bevorzugt 0,1 % zu reduzieren. Die optische Grundkopplung $D_{SG}$ der Sendelichtquelle 2 kann also vernachlässigt werden. Sie wird komplett durch die elektrooptisch erzeugte Grundkopplung $D_{EOGK}$ von der Grundkopplungsstromquelle 15 ersetzt.

Aus der oben genannten Gleichung 1 folgt deshalb für die erfindungsgemäße Messanordnung 1 unter der Bedingung, dass $D_{SG} \ll D_{EOGK}$ ist, die Gleichung 2:

$$\frac{I_c}{I_s} = \frac{\eta_s}{\eta_c} \cdot \frac{D_{SF} + D_{EOGK}}{D_c}$$

Der Kompensationssteuerstrom $I_c$ zur Einstellung des Arbeitspunktes ohne Messobjekt ist also nur von der elektrooptischen Grundkopplung $D_{EOGK}$ abhängig und wird somit nur durch den Grundkopplungssteuerstrom ($I_{EOGK}$) eingestellt.

In einer bevorzugten Ausführungsform ist die Grundkopplungsstromquelle 15 nicht als eigene Stromquelle realisiert. Vielmehr wird sie bevorzugt durch die regelbare Stromquelle 9 zur Erzeugung des getakteten Sendesteuerstroms für die Sendelichtquelle 2 und durch einen Spannungsteiler 19 gebildet. Vorzugsweise wird dabei ein ohmscher Spannungsteiler verwendet.

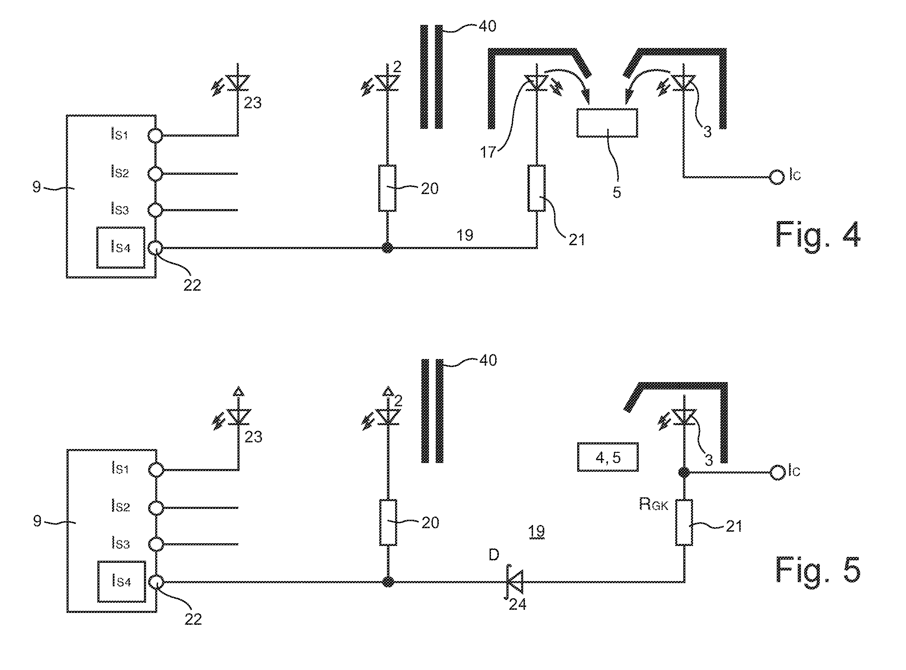

Fig. 4 zeigt einen derartigen Spannungsteiler 19 bei Verwendung einer eigenen (separaten) Grundkopplungslichtquelle 17. Der Sendesteuerstrom, der an einem Stromtreiberausgang 22 ($I_{S4}$) in Fig. 4 anliegt, wird über einen ohmschen Spannungsteiler 19, der aus den Widerständen 20 und 21 besteht, gebildet. Der Strom am Stromtreiberausgang 22, der der regelbaren Stromquelle 9 entspricht, wird im Verhältnis der Widerstände 20 und 21 präzise zwischen der Sendelichtquelle 2 und der Grundkopplungslichtquelle 17 aufgeteilt. Hierbei ist die Grundkopplungslichtquelle 17 für die elektrooptisch erzeugte Grundkopplung verantwortlich. Die optische Grundkopplung kann somit unabhängig von der Kompensatorkopplung $D_C$ der Kompensationslichtquelle 3 gewählt und eingestellt werden. Durch geeignete Wahl der Widerstände 20 und 21 ist es auch möglich, praktisch den gesamten Sendesteuerstrom des Stromtreiberausgangs 22 der Sendelichtquelle 2 zur Verfügung zu stellen. Dies kann erfolgen, wenn eine geringe elektrooptische Grundkopplung ausreicht. In diesem Fall kann in Messanordnungen 1, die eine optionale weitere Sendelichtquelle 23 zur Verstärkung der Sendeleistung umfassen, auf diese weitere Sendelichtquelle 23 verzichtet werden. Die Messanordnung wird dadurch insgesamt preisgünstiger. Die Verwendung eines Spannungsteilers 19 hat jedoch den Nachteil, dass das Verhältnis der Widerstände 20, 21 fest vorgegeben ist und nur durch Umlöten und Austauschen eines Widerstands geändert werden kann. Eine derartige Schaltung ist folglich recht aufwändig an geänderte Einsatzmöglichkeiten der Messanordnung 1 anpassbar.

Die Anordnung gemäß Fig. 4 hat jedoch den Nachteil, dass teilweise eine geringe Mitkopplung der Sendelichtquelle 2 während der Kompensationsphase nicht ausgeschlossen werden kann. In einigen Anwendungen kann eine derartige Mitkopplung erwünscht sein, beispielsweise zur Kennlinienformung. Sollte eine derartige Mitkopplung der Sendelichtquelle 2 jedoch unerwünscht sein, eignet sich eine Schaltungsanordnung gemäß Fig. 5. Hierbei wird auf die Grundkopplungslichtquelle 17 verzichtet. Stattdessen wird die Kompensationslichtquelle 3 mit der Phase A des Sendesteuerstroms gespeist. Es hat sich als vorteilhaft erwiesen, in diesem Fall die Grundkopplungsstromquelle 15 durch die Sendestromquelle 9 für die Sendelichtquelle 2 und einen ohmschen Spannungsteiler 19 mit einer Diode 24 zu realisieren. Bevorzugt ist die Diode 24 eine Schottky-Diode. Allerdings sind hierbei Temperatureinflüsse, die durch die Schottky-Diode auftreten können, zu beachten. Vorteilhaft an dieser Ausführung ist es jedoch, dass keine zusätzliche Grundkopplungslichtquelle notwendig ist.

Die Anordnungen gemäß den Fig. 4 und 5 können als technischer Zwischenschritt bei der Realisierung der Grundkopplungsstromquelle 15 angesehen werden, bei dem im Allgemeinen die Grundkopplungsstromquelle 15 durch einen gerichteten Stromteiler bestehend aus zwei Widerständen 20, 21 und einer optionalen Diode 24 realisiert sind. In einer bevorzugten Ausführungsform wird die Grundkopplungsstromquelle 15 durch die Sendestromquelle (regelbare Stromquelle 9) gebildet und der Grundkopplungssteuerstrom durch Parametrisieren des Sendesteuerstroms erzeugt. Vorzugsweise erfolgt die Parametrisierung der Stromanteile der Phase A (des Sendesteuerstroms für die Sendelichtquelle 2) in einem elektronischen Baustein, beispielsweise einem Chip oder einem Prozessor. Dies ist die kostengünstigste, robusteste und gleichzeitig flexibelste sowie einfachste Lösung.

Die parametrisierten Stromanteile der Phase A werden dem Kompensationsstrom zugeschlagen. Der Steuerchip ist dabei um die Funktion der elektrooptischen Grundkopplung erweitert. Vorteilhaft hierbei ist, dass der Stromanteil der elektrooptischen Grundkopplung je nach Realisierung oder Parametrisierung proportional zum Sendesteuerstrom der Sendelichtquelle 2 sein oder unabhängig davon eingestellt werden kann. Beispielsweise ist es möglich, eine Anpassung, Konfiguration oder auch Umkonfigurierung des Grundkopplungssteuerstroms bei der integrierten Lösung in dem Regelungschip durch Software jederzeit vorzunehmen. Dadurch wird die Attraktivität und Wirtschaftlichkeit deutlich erhöht.

Durch die Integration der elektrooptischen Grundkopplungsfunktion in den Regelungschip entstehen keine Mehrkosten bei der Realisierung dieser Funktion. Lediglich bei der Chipentwicklung muss diese Funktion einmalig integriert werden. In Bezug auf den reinen Hardwareaufwand, wie beispielsweise den Platzbedarf oder die Temperaturstabilität oder ähnlicher Werte bzw. Charakteristika ist diese Lösung optimal. Die Integration der elektrooptischen Grundkopplungsfunktion in den Regelungschip ermöglicht es, mit den Sendesteuerströmen phasensynchrone Grundkopplungssteuerströme in die Kompensationslichtquelle 3 bzw. eine Kompensationstreiberschaltung einzuspeisen. Diese Ströme sind frei parametrisierbar auf einen beliebigen Wert oder auf eine einstellbare Proportionalität zu dem Sendesteuerstrom. Insgesamt ergibt sich hierdurch ein sehr flexibler Einsatz dieser Funktion.

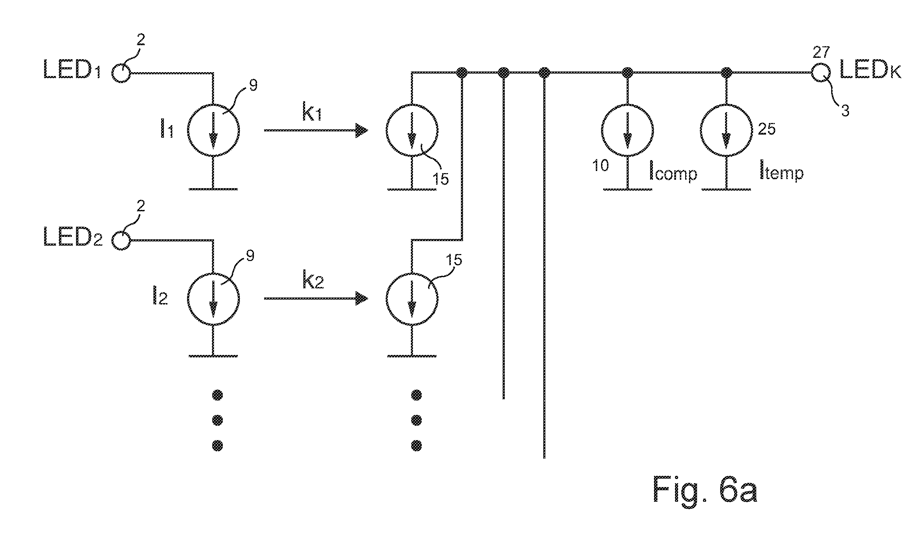

Die Figuren 6a bis d zeigen das Prinzipbild des Regelungschips der Messanordnung 1 für den Fall, dass mehrere Sendelichtquellen 2 vorhanden sind. Die als $LED_1$ und $LED_2$ bezeichneten Sendelichtquellen 2 werden jeweils durch eine steuerbare Stromquelle 9 ($I_1$, $I_2$) gespeist. Gleiches gilt für weitere (nicht gezeigte) Sendelichtquellen 2, die dann als $LED_3$, $LED_4$, ... bezeichnet werden.

Die für die erfindungsgemäße Messanordnung 1 erforderliche Kompensationslichtquelle 3 ist ebenfalls als LED ausgeführt und wird als $LED_K$ bezeichnet. Sie ist an den Anschluss 27 der Schaltung angeschlossen. Darüber hinaus ist in den Figuren 6a bis c auch eine steuerbare Kompensationsstromquelle 10 gezeigt, um die Kompensationslichtquelle 3 anzusteuern. Eine weitere Stromquelle zur Kompensation von Temperatureinflüssen ist parallel zur Kompensationsstromquelle 10 geschaltet. Diese Stromquelle wird als Temperaturkompensationsstromquelle 25 bezeichnet.

Die Ausführungsform gemäß Fig. 6a zeigt ein Prinzipbild der Schaltung ähnlich der Schaltung in den Figuren 4 und 5. Anstelle eines ohmschen Spannungsteilers 19 (Fig. 4, 5) werden einzelne Grundkopplungsstromquellen 15 eingesetzt, die die jeweiligen Widerstände ersetzen. Dies hat den Vorteil, dass für jede Applikation eine einfache Anpassung der Messschaltung durch einfache Änderung des Stromwerts in der steuerbaren Grundkopplungsstromquelle 15 erzeugt werden kann. Jede Sendestromquelle 9 der einzelnen $LED_1$, $LED_2$, ... weist eine korrespondierende Grundkopplungsstromquelle 15 auf. Dabei besteht ein fester linearer Zusammenhang zwischen dem Sendestrom der jeweiligen Sendestromquelle 15 für die einzelnen $LED_1$, $LED_2$, $LED_3$, ... und dem Grundkopplungsstrom der Grundkopplungsstromquelle 15 der jeweiligen Sendelichtquelle ($LED_1$, $LED_2$, ...). Die Verwendung der Grundkopplungsstromquellen 15 hat den Vorteil, dass der Faktor $k_1$, $k_2$, ..., der der Grundkopplungsfaktor der jeweiligen Sendelichtquelle 2 ist, nahezu beliebig parametrisiert sein kann. In der Regel wird der Faktor $k_1$, $k_2$, ... jeweils kleiner 1 gewählt. Es ist selbstverständlich auch möglich, Grundkopplungsfaktoren $k_i$ größer 1 oder gleich 1 auszuwählen. Die einzelnen Grundkopplungsfaktoren

$k_i$ (i = 1, 2, ...) sind vorzugsweise unterschiedlich, da sie von der jeweiligen Sendelichtquelle 2 und deren Positionierung in der Anordnung abhängen.

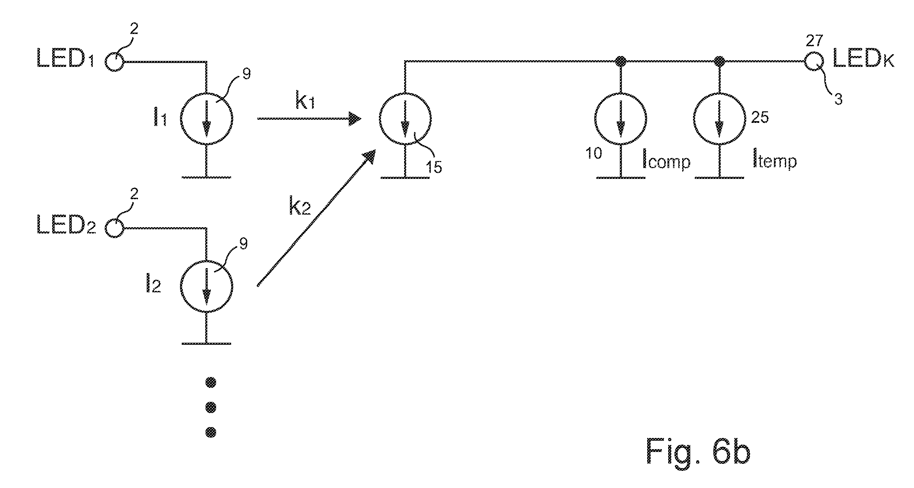

Fig. 6b zeigt nun eine Ausführungsform, bei der die einzelnen Grundkopplungsstromquellen 15 für die einzelnen Sendelichtquellen 2 entfallen, bis auf eine Grundkopplungsstromquelle 15 der ersten Sendelichtquelle 2 (LED$_1$). Diese Grundkopplungsstromquelle 15 wird im Multiplexverfahren betrieben und erzeugt so für jede Sendelichtquelle 2 einen Grundkopplungsstrom. Dabei wird der jeweilige Grundkopplungsstrom nacheinander für die Sendelichtquellen erzeugt. Es besteht also ein Grundkopplungsfaktor $k_i$ (i = 1, 2, ...) zwischen der Grundkopplungsstromquelle 15 und den einzelnen Sendestromquellen 9 (für die LED$_1$, LED$_2$, ...).

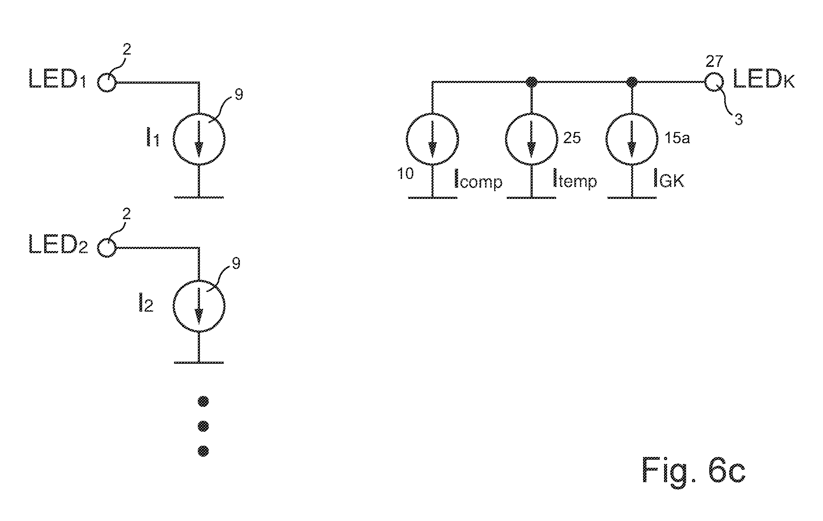

Fig. 6c zeigt eine Ausführungsform, bei der der lineare Zusammenhang zwischen der Sendestromquelle 2 und der Grundkopplungsstromquelle 15 aufgehoben wird. Anstelle der bisherigen Grundkopplungsstromquellen 15 ist hier eine regelbare Grundkopplungsstromquelle 15a angeordnet. Bei dieser wird nicht einmalig in Abhängigkeit von der Applikation ein fester Stromwert der Grundkopplungsstromquelle 15 für die jeweilige Sendelichtquelle 2 (LED$_1$, LED$_2$, ...) eingestellt, um eine gewünschte Grundkopplung abhängig von dem Sendestrom der LED zu erzielen. Vielmehr ist die regelbare Grundkopplungs-stromquelle 15a frei einstellbar. Sie kann beispielsweise rein über Software gesteuert und eingestellt werden. Es ist auch möglich, die Werte zur Einstellung der regelbaren Grundkopplungsstromquelle 15a mittels Werten zu speisen, die beispielsweise in einer Tabelle oder als Funktion in einem IC hinterlegt sind. Dies hat deutliche Vorteile bei der Implementierung im IC und bei der Applikation. Besonders vorteilhaft für die Anwendung ist, dass die Flexibilität und Variabilität steigt. Es ist also möglich, keinen fest vorgegebenen Grundkopplungsfaktor $k_i$ einzustellen, sondern einen beliebigen Wert, der unabhängig von dem Sendestrom ist. Selbstverständlich ist es auch möglich, Kopplungswerte $k_i$ einzustellen, wie es in den Ausführungsformen der Figuren 6a und b beschrieben ist.

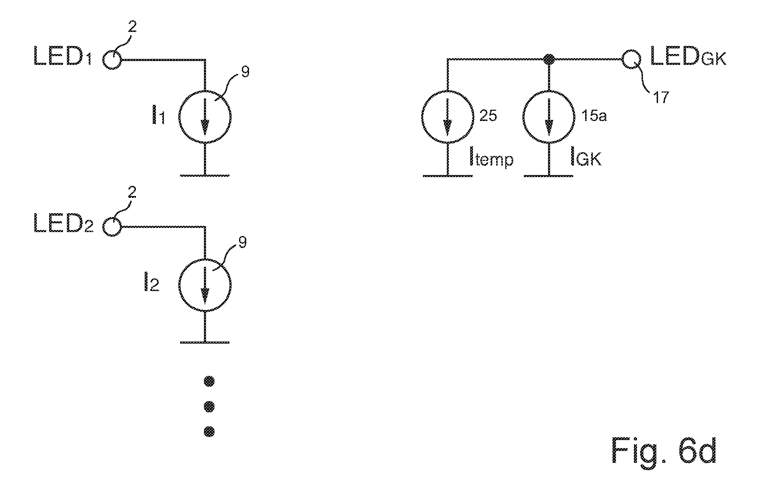

In den Ausführungsformen gemäß der Figuren 6a bis c wird jeweils die Kompensationslichtquelle 3 als Grundkopplungslichtquelle 17 verwendet. In der allgemeinsten Ausbildung wird eine separate Grundkopplungslichtquelle 17 verwendet, die von der Kompensationslichtquelle 3 verschieden ist. Die Grundkopplungslichtquelle 17 wird von der Grundkopplungsstromquelle 15a gesteuert. Optional kann, wie in Fig. 6d gezeigt, der Grundkopplungsstromquelle 15a auch eine Temperaturkompensationsstromquelle 25 parallel geschaltet sein, um Temperatureinflüsse zu kompensieren bzw. zu minimieren.

Die in Fig. 6d gezeigte Ausführungsform zeigt nicht die Kompensationslichtquelle und deren Kompensationsstromquelle. Diese sind selbstverständlich ebenfalls in der Schaltung bzw. im IC enthalten. Der Stromtreiber für die Kompensationslichtquelle 3 (Kompensationsstromquelle 10) kann jedenfalls in einem IC integriert sein. Selbstverständlich ist es möglich, dass der integrierte Baustein (IC) auch als ASIC oder in anderer Form realisiert ist. Es ist ebenfalls möglich, Teile der Funktionen des ICs softwaremäßig zu realisieren.

Die Ausführungsformen gemäß den Figuren 6c und d heben also die hardwareseitige Verkopplung zwischen Sendestrom und Grundkopplungsstrom auf, wie sie in den Figuren 6a und b gezeigt ist. Hierbei ist die Steuerung der Grundkopplungslichtquelle (17) frei wählbar und höchst variabel.

**Patentansprüche**

1. Optoelektronische Messanordnung mit einer optischen Fremdlichtkompensation, umfassend

   - eine Sende-Lichtquelle (2) und eine Kompensationslichtquelle (3), die Licht zeitsequentiell getaktet, phasenweise aussenden, wobei das ausgesendete Licht jeweils phasenverschoben ist,
   - einen optischen Empfänger (4), mit einer Photodiode (5) zum Empfangen von Licht, das ein von den Lichtquellen (2, 3) ausgesandtes taktsynchrones Nutzsignal umfasst, und mit einer Verstärkereinheit (6) zum Verstärken eines auf dem empfangenen Nutzsignal beruhenden Nutzsignalstroms,
   - einen Taktgenerator (8) zur Erzeugung eines Taktsignals,
   - einen Demodulator (11) zur taktsynchronen Auswertung des Nutzsignalstroms,
   - eine regelbare Stromquelle (9) zur Erzeugung eines getakteten Sendesteuerstroms für die Sende-Lichtquelle (2),
   - eine regelbare Kompensations-Stromquelle (10) zur Erzeugung eines getakteten Kompensationssteuerstroms für die Kompensationslichtquelle (3), und
   - eine Reglereinheit (12) zur Erzeugung wenigstens eines Ansteuersignals für die regelbare Stromquelle (9) und/oder Kompensations-Stromquelle (10), wobei die Reglereinheit (12) so ausgebildet ist, dass die Kompensationslichtquelle (3) und/oder die Sende-Lichtquelle (2) durch Steuerung des Kompensationssteuerstroms und/oder des Sende-Steuerstroms in ihrer Lichtintensität in der Amplitude derart regelbar ist, dass der zwischen unterschiedlichen Phasen auftretende taktsynchrone Nutzsignalstrom zu Null wird,

   **gekennzeichnet durch**

- eine steuerbare Grundkopplungs-Stromquelle (15) zur Erzeugung eines getakteten Grundkopplungs-Steuerstroms, wobei bevorzugt die Grundkopplungs-Stromquelle (15) mit dem Taktsignal des Taktgenerators (8) getaktet wird,
- eine Grundkopplungs-Lichtquelle (17), die von der Sende-Lichtquelle (2) verschieden ist und mit dem Grundkopplungs-Steuerstrom gespeist wird und Licht direkt zu dem optischen Empfänger (4) sendet;
- der Grundkopplungs-Steuerstrom derart eingestellt wird, dass eine gewünschte Empfindlichkeit der Messanordnung (1) erzielt wird und/oder ein gewünschter Arbeitspunkt der Reglereinheit einstellbar ist,
- wobei ohne Anwesenheit eines zu erfassenden Objekts (13) die Reglereinheit (12) die Sende-Lichtquelle (2) und/oder die Kompensationslichtquelle (3) derart regelt, dass das von der Grundkopplungs-Lichtquelle (15) empfangene Nutzsignal ausgeregelt wird.

2. Messanordnung nach Anspruch 1, **dadurch gekennzeichnet, dass** die mit dem Grundkopplungs-Steuerstrom gespeiste Grundkopplungs-Lichtquelle (15) die Kompensationslichtquelle (3) ist und die Messanordnung (1) ein Additionsglied (18) umfasst, in dem der Grundkopplungs-Steuerstrom und der Kompensationssteuerstrom addiert werden bevor sie der Kompensationslichtquelle (3) zugeführt werden.

3. Messanordnung nach Anspruch 1 oder 2 , **dadurch gekennzeichnet, dass**

- die Sende-Lichtquelle (2) derart angeordnet ist, dass die Grundkopplung zwischen der Sende-Lichtquelle (2) und der Photodiode (5) maximal 10% des ausgestrahlten Lichts der Sende-Lichtquelle (2) ist, bevorzugt maximal 7%, 5%, 2%, 1% oder bevorzugt annähernd Null ist oder keine direkte Grundkopplung besteht.

4. Messanordnung nach einem der vorhergehenden Ansprüche, **dadurch gekennzeichnet, dass**

- die regelbare Stromquelle (9) zur Erzeugung eines getakteten Sende-Steuerstroms und die regelbare Grundkopplungs-Stromquelle (15) zur Erzeugung eines getakteten Grundkopplungs-Steuerstroms mit dem Taktsignal des Taktgenerators (8) getaktet wird,
- die regelbare Kompensations-Stromquelle (10) zur Erzeugung eines getakteten Kompensationssteuerstroms mit dem invertierten Taktsignal des Taktgenerators (8) getaktet wird.

5. Messanordnung nach einem der vorhergehenden Ansprüche, **dadurch gekennzeichnet, dass** der Grundkopplungs-Steuerstrom derart eingestellt wird, dass die Grundkopplung der Sende-Lichtquelle (2) generiert und/oder verändert wird.

6. Messanordnung nach einem der vorhergehenden Ansprüche, **dadurch gekennzeichnet, dass** die Sende-Lichtquelle (2), die Grundkopplungs-Lichtquelle (17) und/oder die Kompensationslichtquelle (3) eine LED ist.

7. Messanordnung nach einem der vorhergehenden Ansprüche, **dadurch gekennzeichnet, dass** die Grundkopplungs-Stromquelle (15) durch die Stromquelle zur Erzeugung eines getakteten Sende-Steuerstroms für die Sende-Lichtquelle (2) und einen Spannungsteiler (19), bevorzugt durch einen ohmschen Spannungsteiler, realisiert ist.

8. Messanordnung nach dem vorhergehenden Anspruch, **dadurch gekennzeichnet, dass** die Grundkopplungs-Stromquelle (15) durch die Stromquelle (9) für die Sende-Lichtquelle (2) und einen ohmschen Spannungsteiler (19) mit einer Diode (24), bevorzugt mit einer Schottky-Diode, realisiert ist.

9. Messanordnung nach einem Ansprüche 1 bis 6, **dadurch gekennzeichnet, dass** die Grundkopplungs-Stromquelle (15) durch die Stromquelle (9) für die Sende-Lichtquelle (2) und der Grundkopplungs-Steuerstroms durch parametrisierten den Sendesteuerstrom gebildet wird, wobei die Generierung des parametrisierten Grundkopplungs- Steuerstroms in einem Chip erfolgt.

10. Messanordnung nach einem der vorhergehenden Ansprüche, **dadurch gekennzeichnet, dass** die Messanordnung (1) mehrere SendeLichtquellen (2) umfasst, die sequentiell nacheinander in der Regelschleife durch die Kompensationslichtquelle (3) kompensiert werden und für die jeweils ein Grundkopplungs-Steuerstrom erzeugt wird.

11. Messanordnung nach einem der vorhergehenden Ansprüche, **dadurch gekennzeichnet, dass** die Stromquellen (9, 10, 15), insbesondere die steuerbare Stromquelle (9) für die Sende-Lichtquelle (2) und die steuerbare Grundkopplungs-Stromquelle (15), von einem oder mehreren Signalgebern (16) gespeist werden, wobei der Signalgeber (16) bevorzugt in dem Chip integriert ist.

Fig. 1

EP 2 418 512 A1

Fig. 2

Fig. 3

Fig. 4

Fig. 5

Fig. 6a

EP 2 418 512 A1

Fig. 6b

EP 2 418 512 A1

Fig. 6c

Fig. 6d

Europäisches
Patentamt

European
Patent Office

Office européen
des brevets

**EUROPÄISCHER RECHERCHENBERICHT**

**Nummer der Anmeldung**

EP 10 19 6902

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 100 01 955 A1 (REIME GERD [DE]) 19. Juli 2001 (2001-07-19) * Spalte 3, Zeilen 1-48; Abbildungen 1,2a,10 * * Spalte 4, Zeilen 1-9,67 - Spalte 5, Zeile 8 * ----- | 1-3,5-11 | INV. G01S17/02 H03K17/78 |
| A,D | US 5 666 037 A (REIME GERD [DE]) 9. September 1997 (1997-09-09) * Spalten 7-8; Abbildungen 3,5 * ----- | 1-11 | |
| A,D | EP 1 671 160 B1 (MECHALESS SYSTEMS GMBH [DE]) 2. Mai 2007 (2007-05-02) * Absätze [0003], [0004], [0029]; Abbildungen 1-6 * ----- | 1-11 | |
| | | | **RECHERCHIERTE SACHGEBIETE (IPC)** G01S H03K |

Der vorliegende Recherchenbericht wurde für alle Patentansprüche erstellt

| Recherchenort | Abschlußdatum der Recherche | Prüfer |
|---|---|---|
| München | 23. März 2011 | Metz, Carsten |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
...........................................................................................
& : Mitglied der gleichen Patentfamilie, übereinstimmendes Dokument

EPO FORM 1503 03.82 (P04C03)

EP 2 418 512 A1

**ANHANG ZUM EUROPÄISCHEN RECHERCHENBERICHT**
**ÜBER DIE EUROPÄISCHE PATENTANMELDUNG NR.**

EP 10 19 6902

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

23-03-2011

| Im Recherchenbericht angeführtes Patentdokument | | Datum der Veröffentlichung | Mitglied(er) der Patentfamilie | | Datum der Veröffentlichung |
|---|---|---|---|---|---|
| DE 10001955 | A1 | 19-07-2001 | AT | 251818 T | 15-10-2003 |
| | | | AU | 2847301 A | 31-07-2001 |
| | | | WO | 0154276 A1 | 26-07-2001 |
| | | | EP | 1269629 A1 | 02-01-2003 |
| | | | ES | 2208607 T3 | 16-06-2004 |
| | | | JP | 4574098 B2 | 04-11-2010 |
| | | | JP | 2003526236 T | 02-09-2003 |
| | | | US | 2003020004 A1 | 30-01-2003 |
| US 5666037 | A | 09-09-1997 | AU | 6968494 A | 24-01-1995 |
| | | | WO | 9501561 A1 | 12-01-1995 |
| | | | EP | 0706648 A1 | 17-04-1996 |
| | | | ES | 2110763 T3 | 16-02-1998 |
| | | | FI | 956323 A | 28-02-1996 |
| | | | JP | 3362852 B2 | 07-01-2003 |
| | | | JP | 8512131 T | 17-12-1996 |
| EP 1671160 | B1 | 02-05-2007 | AT | 361477 T | 15-05-2007 |
| | | | DE | 10346741 B3 | 24-03-2005 |
| | | | EP | 1671160 A1 | 21-06-2006 |
| | | | WO | 2005036209 A1 | 21-04-2005 |
| | | | ES | 2287780 T3 | 16-12-2007 |
| | | | JP | 2007508528 T | 05-04-2007 |
| | | | US | 2008042043 A1 | 21-02-2008 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5666037 A
- EP 0706648 B1
- EP 1671160 B1